# EUROPEAN PATENT APPLICATION

(11) **EP 4 712 145 A1**
(43) Date of publication of application: **18.03.2026**
(21) Application number: 24807428.8
(22) Date of filing: 08.05.2024
(51) Int. Cl.: H01L 33/38, H01L 33/62, H01L 33/20, H01L 33/48, H01L 33/44, H01L 33/60, H01L 25/075

(54) **LIGHT-EMITTING DEVICE AND DISPLAY DEVICE COMPRISING SAME**

(30) Priority: 12.05.2023 US 202363465934 P; 07.05.2024 US 202418656810
(71) Applicant: Seoul Viosys Co., Ltd., Ansan-si, Gyeonggi-do 15429 (KR)
(72) Inventor: PARK, Yeon Kyu, Ansan-si, Gyeonggi-do 15429 (KR); CHOI, Hyo Shik, Ansan-si, Gyeonggi-do 15429 (KR)
(74) Representative: Stolmár & Partner Patentanwälte PartG mbB
(86) International application number: PCT/KR2024/006173
(87) International publication number: WO 2024/237552

(57) **Abstract**

A light emitting device according to an embodiment includes: a substrate; a first conductivity type window layer and a mesa disposed on one region of the first conductivity type window layer, in which the mesa is a semiconductor stack including an active layer and a second conductivity type window layer; an adhesive layer disposed between the semiconductor stack and the substrate; a first ohmic layer electrically connected to the first conductivity type window layer; a second ohmic layer electrically connected to the second conductivity type window layer; and a first electrode pad and a second electrode pad disposed on the semiconductor stack to face the substrate, and electrically connected to the first ohmic layer and the second ohmic layer, respectively.

## Description

### [Technical Field]

The present disclosure relates to a light emitting device and a light emitting module or display apparatus, and more particularly, to a red light emitting device having a flip chip structure.

### [Background Art]

In a case of a light emitting device using an AlInGaN-based semiconductor, a light emitting device having a flip chip structure is generally used. The light emitting device having the flip chip structure typically has a structure that emits light through a growth substrate.

Meanwhile, a light emitting device emitting red light is generally based on an AlInGaP-based semiconductor layer. The AlInGaP-based semiconductor layer is grown on a GaAs substrate, and since the GaAs substrate absorbs red light unlike a sapphire substrate, it is difficult to provide a red light emitting device having a flip chip structure while using the GaAs substrate.

Although red light emitting devices having various structures in which the GaAs substrate is removed have been provided, a research on red light emitting devices having favorable heat dissipation performance is still required.

### [Disclosure]

### [Technical Problem]

Exemplary embodiments provide a red light emitting device having improved luminous efficiency.

### [Technical Solution]

A light emitting device according to an embodiment of the present disclosure includes a substrate; a semiconductor stack having a first conductivity type window layer, an active layer, and a second conductivity type window layer; first conductivity type contact layers arranged on the first conductivity type window layer; first ohmic layers disposed on the first conductivity type contact layers, respectively; second ohmic layers disposed on the semiconductor stack to face the first ohmic layers; a first connection electrode layer connecting the second ohmic layers; a second connection electrode layer connecting the first ohmic layers; an adhesive layer disposed between the first connection electrode layer and the substrate; and first and second electrode pads disposed under the semiconductor stack to face the substrate, in which the first electrode pad is electrically connected to the second connection electrode layer, and the second electrode pad is electrically connected to the first connection electrode layer.

The semiconductor stack may include AlInGaP-based semiconductor layers, and the active layer may be configured to emit red light.

In an embodiment, the first conductivity type contact layers may include GaAs.

The semiconductor stack may have at least one hole, and the second electrode pad may be electrically connected to the first connection electrode layer through the at least one hole.

In an embodiment, the second electrode pad may be electrically connected to the first connection electrode layer through the hole, and electrically connected to the second ohmic layers through the first connection electrode layer.

In another embodiment, the second ohmic layers may include a second ohmic layer disposed over the hole, and the second electrode pad may be electrically connected to the second connection electrode layer through the second ohmic layer disposed over the hole.

The first connection electrode layer may transmit light generated from the active layer, and the second connection electrode layer may reflect light generated from the active layer.

The semiconductor stack may further include a second conductivity type contact layer disposed on the second conductivity type window layer, and the second ohmic layers may be in ohmic contact with the second conductivity type contact layer.

The second conductivity type contact layer and the second conductivity type window layer may have roughened surfaces.

The light emitting device may further include a first insulation layer disposed between the semiconductor stack and the first connection electrode layer, the first insulation layer may have first openings exposing the second ohmic layers, and the first connection electrode layer may be electrically connected to the second ohmic layers through the first openings.

In an embodiment, each of the first openings may be disposed on the second ohmic layers. In another embodiment, each of the first openings may have an area larger than those of the second ohmic layers.

The first insulation layer may have a second opening allowing electrical connection between the second electrode pad and the first connection electrode layer.

In an embodiment, the semiconductor stack may have at least one hole, the second opening of the first insulation layer may be disposed over the hole, and the second electrode pad may be electrically connected to the first connection electrode layer through the hole and the second opening.

In an embodiment, a side surface of the first connection electrode layer and a side surface of the first insulation layer may be covered with the adhesive layer.

In another embodiment, the side surface of the first insulation layer may be in flush with a side surface of the adhesive layer.

In an embodiment, the side surface of the first insulation layer may be in flush with the side surface of the first connection electrode layer.

The light emitting device may further include a second insulation layer disposed between the semiconductor stack and the second connection electrode layer, the second insulation layer may have first openings exposing the first ohmic layers, and the second connection electrode layer may be electrically connected to the first ohmic layers through first openings of the second insulation layer.

In an embodiment, each of the first openings of the second insulation layer may be disposed on the first ohmic layers. In another embodiment, each of the first openings of the second insulation layer may have an area larger than those of the first ohmic layers.

The light emitting device may further include a third insulation layer covering the second connection electrode layer, the first electrode pad may be electrically connected to the second connection electrode layer through the third insulation layer, and the second electrode pad may be electrically connected to the first connection electrode layer through the third insulation layer.

In an embodiment, the semiconductor stack may have a hole, the third insulation layer may cover a sidewall of the hole and may have an opening in the hole, and the second electrode pad may be electrically connected to the first connection electrode layer through the hole.

The third insulation layer may cover a side surface of the second insulation layer, a side surface of the second connection electrode layer, a side surface of the semiconductor stack, and the side surface of the adhesive layer.

In an embodiment, the side surface of the adhesive layer may be in flush with a side surface of the substrate.

A light emitting device according to an embodiment of the present disclosure includes: a substrate; a first conductivity type window layer and a mesa disposed on one region of the first conductivity type window layer, in which the mesa is a semiconductor stack including an active layer and a second conductivity type window layer; an adhesive layer disposed between the semiconductor stack and the substrate; a first ohmic layer electrically connected to the first conductivity type window layer; a second ohmic layer electrically connected to the second conductivity type window layer; and a first electrode pad and a second electrode pad disposed on the semiconductor stack to face the substrate, and electrically connected to the first ohmic layer and the second ohmic layer, respectively.

A side surface of the mesa may have a plurality of inclined surfaces with different inclination angles.

The inclined surfaces on the side surface of the mesa may become gentler as they are closer to the substrate.

A side surface of the first conductivity type window layer may have a plurality of inclined surfaces with different inclination angles.

A stacking order of the inclined surfaces with different inclination angles on the side surface of the mesa may be different from a stacking order of the inclined surfaces with different inclination angles on the side surface of the first conductivity type window layer.

The inclined surfaces on the side surface of the first conductivity type window layer become gentler as they are farther from the substrate.

The first ohmic layer may have regions with different thicknesses from one another.

A region of the first ohmic layer with a relatively small thickness may be surrounded by a region with a relatively large thickness.

The second ohmic layer may have regions with different thicknesses from one another.

A region of the second ohmic layer with a relatively small thickness may be surrounded by a region with a relatively large thickness.

At least one of the first ohmic layer and the second ohmic layer may include a protrusion protruding toward a corresponding window layer.

In an embodiment, the first conductivity type window layer may be an n-type, and the second conductivity type window layer may be a p-type.

In another embodiment, the first conductivity type window layer may be a p-type, and the second conductivity type window layer may be an n-type. Furthermore, at least one end of the second ohmic layer may be spaced apart from the second conductivity type window layer.

The adhesive layer may include an inner region disposed under the semiconductor stack and an outer region disposed outside the semiconductor stack, and the inner region may be thicker than the outer region.

The outer region may include portions of different thicknesses, and at least some of the portions of the outer region may have a thickness greater than that of a portion closer to the inner region.

The light emitting device may further include an insulation layer covering the first ohmic layer, the second ohmic layer, and the semiconductor stack, and the first electrode pad and the second electrode pad may be connected to the first ohmic layer and the second ohmic layer, respectively, through openings of the insulation layer.

In an embodiment, at least a portion of an upper surface of the substrate may be exposed to the outside of the adhesive layer and the insulation layer, and a side surface of the adhesive layer may be covered with the insulation layer.

In another embodiment, the insulation layer may cover an upper surface of the adhesive layer, and the side surface of the adhesive layer may be exposed to the outside.

The light emitting device may further include a reflection metal layer, and the insulation layer may include a lower insulation layer covering the first ohmic layer and the second ohmic layer and an upper insulation layer covering the lower insulation layer, and the reflection metal layer may be disposed between the lower insulation layer and the upper insulation layer.

The reflection metal layer may be disposed over the mesa, and may partially overlap the second ohmic layer.

The mesa, the first conductivity type window layer, and edges of the first and second electrode pads may include curved regions having different curvatures from one another.

Other features and technical advantages of the present disclosure will be discussed in the detailed description set forth below or will be readily understood from the description of the detailed description.

### [Description of Drawings]

FIG. 1A is a schematic plan view illustrating a light emitting device according to a first embodiment of the present disclosure.
FIG. 1B is a cross-sectional view taken along line A-A' of FIG. 1A.
FIGs. 2A, 2B, and 2C illustrate various cross-sectional shapes of concavo-convex patterns formed on a surface of a second conductivity type semiconductor layer.
FIGs. 3 through 17 are schematic cross-sectional views illustrating a method of manufacturing the light emitting device according to the first embodiment.
FIG. 18 is a schematic cross-sectional view illustrating a light emitting device according to a second embodiment of the present disclosure.
FIG. 19 is a schematic cross-sectional view illustrating a light emitting device according to a third embodiment of the present disclosure.
FIG. 20 is a schematic cross-sectional view illustrating a light emitting device according to a fourth embodiment of the present disclosure.
FIG. 21 is a schematic cross-sectional view illustrating a light emitting device according to a fifth embodiment of the present disclosure.
FIG. 22 is a schematic cross-sectional view illustrating a light emitting device according to a sixth embodiment of the present disclosure.
FIGs. 23 and 24 are schematic plan views illustrating light emitting devices according to various embodiments.
FIG. 25 is a schematic cross-sectional view illustrating a module to which embodiments are applied.
FIG. 26 is a schematic plan view illustrating a display module or display apparatus to which embodiments are applied.
FIG. 27 is a schematic plan view illustrating a display apparatus to which embodiments are applied.
FIG. 28 is a schematic plan view illustrating a light emitting device according to a seventh embodiment.
FIG. 29 is a schematic cross-sectional view taken along line B-B' in FIG. 28.
FIG. 30 is a partial cross-sectional view of FIG. 29.
FIG. 31 is a schematic partial cross-sectional view illustrating a first ohmic layer of the light emitting device according to the seventh embodiment.
FIG. 32 is a schematic partial cross-sectional view illustrating a second ohmic layer of the light emitting device according to the seventh embodiment.
FIG. 33 is a schematic partial cross-sectional view illustrating a modified example of the first ohmic layer of the light emitting device according to the seventh embodiment.
FIG. 34 is a schematic cross-sectional view illustrating a light emitting device according to an eighth embodiment.
FIG. 35 is a schematic plan view illustrating a light emitting device according to a ninth embodiment.
FIG. 36 is a schematic cross-sectional view illustrating a module to which embodiments are applied.
FIG. 37 is a schematic plan view illustrating various light emitting devices in a light emitting apparatus.

### [Detailed Description of the Illustrated Embodiments]

Hereinafter, embodiments will be described in detail with reference to the accompanying drawings. The following embodiments are provided by way of example so as to fully convey the spirit of the present disclosure to those skilled in the art to which the present disclosure pertains. Accordingly, the inventive concepts are not limited to the embodiments disclosed herein and can also be implemented in different forms. In the drawings, widths, lengths, thicknesses, and the like of elements can be exaggerated for clarity and descriptive purposes. Throughout the specification, like reference numerals denote like elements having the same or similar functions.

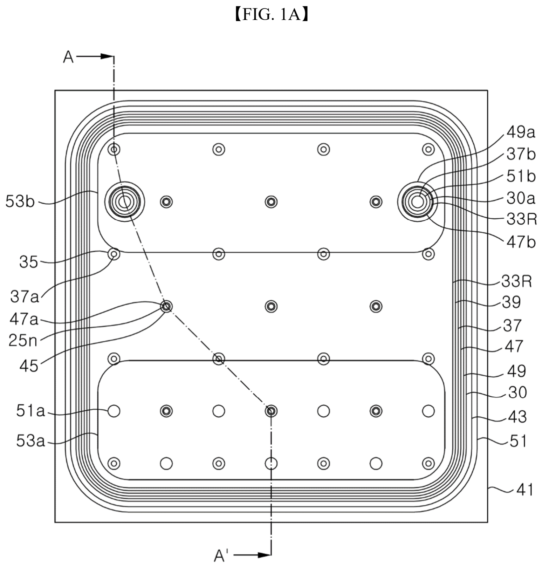

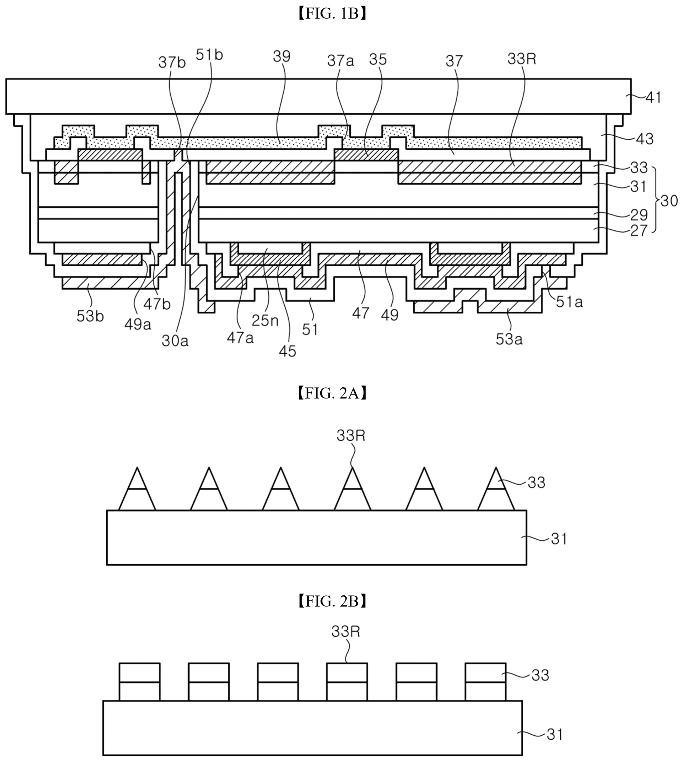

FIG. 1A is a schematic plan view illustrating a light emitting device according to a first embodiment, and FIG. 1B is a cross-sectional view taken along line A-A' in FIG. 1A.

Referring to FIGs. 1A and 1B, the light emitting device according to the first embodiment may include a substrate 41, a semiconductor stack 30, a first conductivity type contact layer 25n, a first ohmic layer 45, a second ohmic layer 35, a first insulation layer 37, a second insulation layer 47, a first connection electrode layer 39, an adhesive layer 43, a second connection electrode layer 49, a third insulation layer 51, a first electrode pad 53a, and a second electrode pad 53b. The semiconductor stack 30 may include a first conductivity type window layer 27, an active layer 29, a second conductivity type window layer 31, and a second conductivity type contact layer 33.

The substrate 41 is for supporting the light emitting device, and bonded to the semiconductor layers through the adhesive layer 43. The substrate 41 is distinct from a growth substrate used to grow the semiconductor stack 30. A type of substrate 41 is not particularly limited as long as it transmits light generated in the active layer 29, and various substrates such as a sapphire substrate, a GaP substrate, a SiC substrate, an organic substrate, and others may be used.

As shown in plan view of FIG. 1A, the substrate 41 may have a rectangular or square shape. A size of the substrate 41 is not particularly limited and may be variously selected.

The active layer 29 is disposed between the first conductivity type window layer 27 and the second conductivity type window layer 31. The first conductivity type window layer 27, the active layer 29, and the second conductivity type window layer 31 may have a typical AlInGaP-based semiconductor stack structure for emitting red light. The active layer 29 may have a single quantum well structure or a multiple quantum well structure, and may include an InGaP well layer and an AlInGaP barrier layer. The first conductivity type window layer 27 may be formed of, for example, an n-type AlInGaP layer, and the second conductivity type window layer 31 may be formed of, for example, a GaP layer.

At least one first conductivity type contact layer 25n may be disposed on the first conductivity type window layer 27. A plurality of first conductivity type contact layers 25n may be spaced apart from one another to be disposed on the first conductivity type window layer 27. The first conductivity type contact layer 25n may be formed to provide an ohmic contact with the first ohmic layer 45. In addition, the first conductivity type contact layer 25n may have a higher light absorptivity with respect to a wavelength of light generated from the active layer 29 than the first conductivity type window layer 27. In addition, the first conductivity type contact layer 25n may have electrical conductivity higher than that of the first conductivity type window layer 27. For example, it may be formed of a GaAs layer. Since GaAs absorbs light generated in the active layer 29, it is necessary to reduce an area where the first conductivity type contact layer 25n is formed. Accordingly, the first conductivity type contact layer 25n may be disposed in a plurality of regions spaced apart from one another, or may be disposed in an island shape. To reduce light absorption and assist current spreading, the first conductivity type contact layers 25n may be widely distributed within an area of the light emitting device, as shown in FIG. 1A. The number and distribution of the first conductivity type contact layers 25n may be variously changed. In addition, the first conductivity type contact layers 25n may be spaced apart at a predetermined distance, but the inventive concepts are not necessarily limited thereto, and may be variously arranged in consideration of current spreading. For example, the first conductivity type contact layer 25n may be formed of a GaP layer. Accordingly, a difference in lattice constant from the first conductivity type window layer 27 disposed adjacent to the first conductivity type contact layer 25n may be reduced.

The second conductivity type contact layer 33 may be formed to provide an ohmic contact with the second ohmic layer 35. The second conductivity type contact layer 33 may be formed of, for example, GaP heavily doped with p-type impurities. The second conductivity type contact layer 33 may form an upper surface of the semiconductor stack 30.

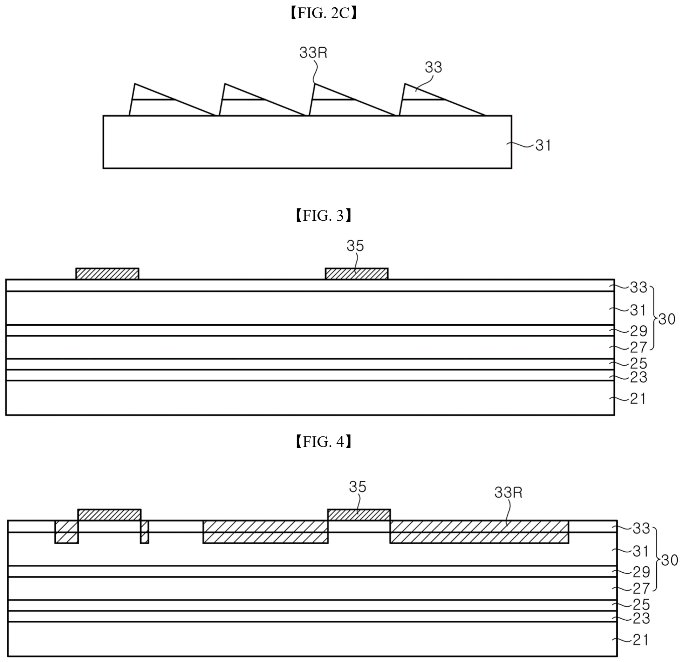

Additionally, roughened surfaces may be formed on the second conductivity type contact layer 33 and the second conductivity type window layer 31. The roughened surface may have various concavo-convex shapes. For example, as shown in FIGs. 2A, 2B, and 2C, a convex portion may have various shapes such as a pyramidal shape, a columnar shape, a saw tooth shape, and others. The roughened surface may be formed using patterning techniques or chemical etching. As shown in FIG. 2C, both side surfaces of one convex portion on the roughened surface may converge in a direction away from the active layer 31 to have a vertex, and inclinations of both side surfaces with respect to the vertex may be different. That is, the both side surfaces may have an asymmetrical shape with respect to the vertex.

The first ohmic layer 45 may be in ohmic contact with the first conductivity type contact layer 25n. The first ohmic layers 45 may be disposed on the first conductivity type contact layers 25n, respectively. As shown in FIG. 1B, the first ohmic layer 45 may cover a side surface and an upper surface of the first conductivity type contact layer 25n. The first ohmic layer 45 may be formed of, for example, a metal such as AuGe, PdGe, or the like.

The second ohmic layer 35 is disposed on the second conductivity type contact layer 33 to be in ohmic contact with the second conductivity type contact layer 33. A plurality of second ohmic layers 35 may be spaced apart from one another. The second ohmic layers 35 may be disposed not to overlap one another in a vertical direction with the first conductivity type contact layers 25n. Accordingly, a path of the current flowing from the second ohmic layer 35 to the first ohmic layer 45 may be increased to spread the current. The second ohmic layer 35 may be formed of, for example, TiAu, AuBe, AuZn, or the like.

The first insulation layer 37 covers exposed surfaces of the second ohmic layer 35 and the semiconductor stack 30. The first insulation layer 37 may cover entire roughened surfaces of the second conductivity type contact layer 33 and the second conductivity type window layer 31. For example, the second insulation layer 37 may have a thickness within a range of 100nm to 500nm. The second insulation layer 37 may have a specific thickness through which light generated in the active layer 29 pass easily. For example, the thickness of the second insulation layer 37 may have a thickness of an odd multiple of 1/(4n) of a wavelength λ of light generated in the active layer 29 (wherein n is a refractive index of the second insulation layer 37) or a similar thickness thereto.

The first insulation layer 37 has first openings 37a exposing the second ohmic layers 35. Each of the first openings 37a may expose the second ohmic layers 35. The first opening 37a may be disposed over the second ohmic layer 35, and an upper surface of the second ohmic layer 35 may be exposed through the first opening 37a. A side surface of the second ohmic layer 35 may cover the first insulation layer 37. The first insulation layer 37 may also have at least one second opening 37b for electrical connection between the first connection electrode layer 39 and the second pad electrode 53b. The second opening 37b will be described again later.

Meanwhile, a surface of the second conductivity type contact layer 33 may be exposed along an edge of the first insulation layer 37. An exposed surface of the second conductivity type contact layer 33 may be covered with the adhesive layer 43.

The first connection electrode layer 39 may be disposed on the first insulation layer 37. The first connection electrode layer 39 may be electrically connected to the second ohmic layers 35 through the first openings 37a. The first connection electrode layer 39 may electrically connect the second ohmic layers 35 spaced apart from each other. The first connection electrode layer 39 may be formed of a transparent conductive layer, for example, a transparent conductive oxide film such as ITO, IZO, or the like.

Although not shown in the drawings, a region disposed in a hole 30a among regions of the first connection electrode layer 39 may have a different thickness from other regions. For example, a thickness of a region of the first connection electrode layer 39 disposed in the hole 30a may be smaller than other regions, or a step may be formed.

When the roughened surfaces are formed on the second conductivity type contact layer 33 and the second conductivity type window layer 31, the first insulation layer 37 may have a shape in which a height thereof changes along the surface.

An edge of the first connection electrode layer 39 may be disposed on the first insulation layer 37, but the inventive concepts are not limited thereto. For example, a side surface of the first connection electrode layer 39 may be in flush with a side surface of the first insulation layer 37, and the first connection electrode layer 39 may cover the side surface of the first insulation layer 37.

The adhesive layer 43 may be disposed between the first connection electrode layer 39 and the substrate 41. The adhesive layer 43 may cover the side surfaces of the first connection electrode layer 39 and the side surfaces of the first insulation layer 37, and be in contact with a portion of the surface of the second conductivity type contact layer 33. The adhesive layer 43 may include, for example, epoxy, polyimide, SU8, spin-on-glass (SOG), or benzocyclobutene (BCB), without being limited thereto. An outer boundary of the adhesive layer 43 may be disposed between an outer boundary of the semiconductor stack 30 and an outer boundary of the substrate 41.

The second insulation layer 47 is disposed under the semiconductor stack 30 to face the first insulation layer 37. The second insulation layer 47 covers the first ohmic layer 45 and the semiconductor stack 30. The second insulation layer 47 may have first openings 47a exposing the first ohmic layer 45, and may have second openings 47b disposed under each of the holes 30a passing through the semiconductor stack 30. Meanwhile, a surface of the first conductivity type window layer 27 may be exposed along an edge of the second insulation layer 47. A thickness of the second insulation layer 47 may be different from that of the first insulation layer 37.

The second connection electrode layer 49 may be disposed on the second insulation layer 47. The second connection electrode layer 49 may connect the first ohmic layers 45 to one another through the first openings 47a of the second insulation layer 47. Unlike the first connection electrode layer 39, the second connection electrode layer 49 may be formed of a metallic reflection layer that reflects light generated in the active layer 29, and may be formed of, for example, Au. The second connection electrode layer 49 may have an opening 49a for forming the hole 30a.

The second connection electrode layer 49 may be limitedly disposed on the second insulation layer 47, and thus, the second insulation layer 47 may be exposed around an edge of the second connection electrode layer 49. However, the inventive concepts are not limited thereto, and a side surface of the second connection electrode layer 49 may be in flush with a side surface of the second insulation layer 47, and in addition, the second connection electrode layer 49 may cover the side surface of the second insulation layer 47.

The hole 30a may pass through the semiconductor stack 30. The hole 30a is formed to electrically connect the second electrode pad 53b to the second conductivity type contact layer 33. At least one hole 30a may be formed, and a plurality of holes 30a may be formed for current spreading. Each of the holes 30a may be formed in the second opening 47b of the second insulation layer 47 and in the opening 49a of the second connection electrode layer 49. The second opening 37b of the first insulation layer 37 may be disposed over the hole 30a.

The third insulation layer 51 may be disposed on the second connection electrode layer 49. The third insulation layer 51 may cover a side surface of the semiconductor stack 30, may further cover a side surface of the adhesive layer 43, and may contact a lower surface of the substrate 41. The third insulation layer 51 may cover the side surfaces of the second insulation layer 47 and the second connection electrode layer 49. In addition, the third insulation layer 51 may cover a sidewall of the hole 30a to separate the second electrode pad 53b from the semiconductor stack 30 within the hole 30a. The third insulation layer 51 extends from one side of the second connection electrode layer 49 to a side surface of the hole 30a. The third insulation layer 51 may have a first opening 51a exposing the second connection electrode layer 49 and a second opening 51b exposing a bottom of the hole 30a.

In an embodiment, the third insulation layer 51 may include a distributed Bragg reflector. Accordingly, the third insulation layer 51 may improve light extraction efficiency by reflecting light generated in the active layer 29 toward the substrate 41. A thickness of the third insulation layer 51 may be different from that of the second insulation layer 47. Alternatively, the thickness of the third insulation layer 51 may be different from that of the first insulation layer 37.

The first electrode pad 53a and the second electrode pad 53b may be disposed on the third insulation layer 51. The first electrode pad 53a is electrically connected to the second connection electrode layer 49 through the first opening 51a of the third insulation layer 51. In the third insulation layer 51 as shown in FIG. 1A, a plurality of first openings 51a may be formed, and the first electrode pad 53a may be connected to the second connection electrode layer 49 through the plurality of first openings 51a. As a result, the first electrode pad 53a may be electrically connected to the first conductivity type window layer 27 through the second connection electrode layer 49, the first ohmic layer 45, and the first conductivity type contact layer 25n.

Meanwhile, the second electrode pad 53b may be electrically connected to the first connection electrode layer 39 through the hole 30a and the second opening 37b of the first insulation layer 37, and may be electrically connected to the second conductivity type contact layer 33 through the first connection electrode layer 39 and the second ohmic layer 35.

The first and second electrode pads 53a and 53b are metallic layers for flip-bonding the light emitting device, and may be formed of, for example, a bonding metal such as AuSn, and the like. As shown in FIG. 1A, the first and second electrode pads 53a and 53b may be disposed to face each other.

According to an embodiment of the present disclosure, a light emitting device capable of flip-chip bonding while emitting red light using an AlInGaP-based semiconductor layer is provided.

FIGs. 3 through 17 are schematic cross-sectional views illustrating a method of manufacturing the light emitting device according to the first embodiment.

First, referring to FIG. 3, an etch stop layer 23, a first conductivity type contact layer 25, a first conductivity type window layer 27, an active layer 29, a second conductivity type window layer 31, and a second conductivity type contact layer 33 may be grown on a substrate 21. The substrate 21 is not particularly limited as long as it can grow a GaAs layer and an AlInGaP-based semiconductor layer. The substrate 21 may be, for example, a GaAs substrate. The etch stop layer 23, the first conductivity type contact layer 25, the first conductivity type window layer 27, the active layer 29, the second conductivity type window layer 31, and the second conductivity type contact layer 33 may be grown on the substrate 21 using a metal organic chemical vapor deposition (MOCVD) method, a molecular beam epitaxial growth method, or the like.

The etch stop layer 23 may be formed of, for example, InGaP, and protects the first conductivity type contact layer 25 when the substrate 21 is etched and removed. The first conductivity type contact layer 25 may be formed of GaAs, for example.

Meanwhile, second ohmic layers 35 may be formed on the second conductivity type contact layer 33. The second ohmic layer 35 is in ohmic contact with the second conductivity type contact layer 33. The second ohmic layer 35 may be formed of, for example, TiAu, AuBe, AuZn, or the like. As shown in FIG. 1A, the second ohmic layers 35 may be distributed on the second conductivity type contact layer 33 at regular intervals. However, the inventive concepts are not limited thereto, and the second ohmic layers 35 may be arranged in various ways.

Referring to FIG. 4, a roughened surface 33R may be formed on the second conductivity type contact layer 33 exposed around the second ohmic layers 35. A concave portion of the roughened surface 33R may extend to the second conductivity type window layer 31. As shown in FIG. 4, a region near an edge of the second conductivity type contact layer 33 may be left as a flat surface without forming the roughened surface 33R. A shape of the roughened surface 33R may vary, and some examples are schematically shown in FIGs. 2A, 2B, and 2C. The roughened surface 33R may be formed to improve light extraction efficiency, but is optional.

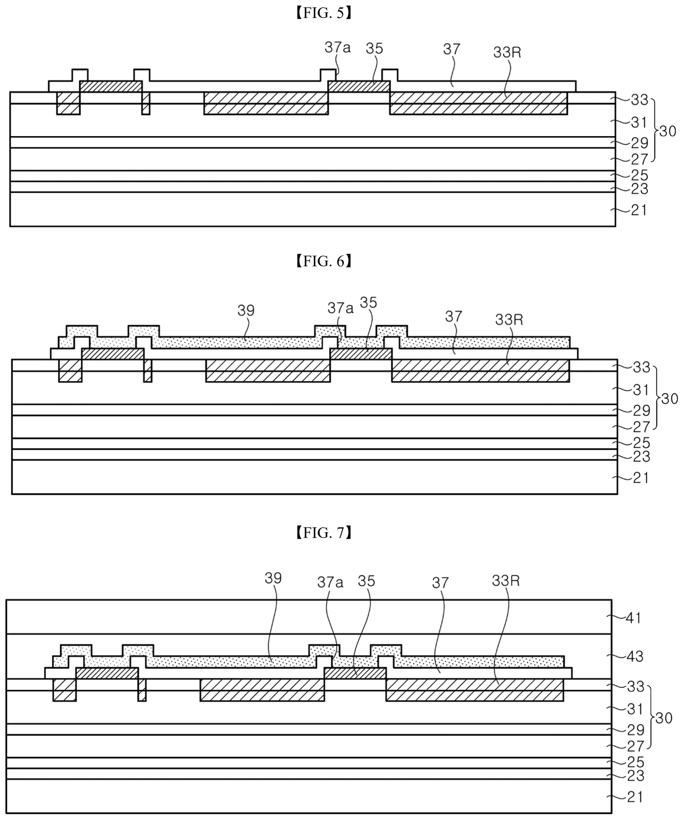

Referring to FIG. 5, a first insulation layer 37 is formed on the second ohmic layers 35 and the second conductivity type contact layer 33. The first insulation layer 37 may be formed of, for example, a silicon oxide layer. The first insulation layer 37 may cover an entire roughened surface. The first insulation layer 37 may be patterned, and first openings 37a exposing the second ohmic layers 35 may be formed. In addition, the first insulation layer 37 may be patterned to expose the second conductivity type contact layer 33 around an edge of the first insulation layer 37.

Referring to FIG. 6, a first connection electrode layer 39 may be formed on the first insulation layer 37. The first connection electrode layer 39 may be formed of a transparent conductive oxide layer such as ITO, IZO, or the like. The first connection electrode layer 39 may connect the second ohmic layers 35 exposed by the first openings 37a to one another.

The first connection electrode layer 39 may be patterned such that an edge of the first connection electrode layer 39 is disposed on the first insulation layer 37. As shown in FIG. 6, an upper surface of the first insulation layer 37 may be exposed around the edge of the first connection electrode layer 39. However, the inventive concepts are not limited thereto, and a side surface of the first connection electrode layer 39 may be in flush with a side surface of the first insulation layer 37, and the first connection electrode layer 39 may cover the side surface of the first insulation layer 37.

Referring to FIG. 7, a substrate 41 is attached to the first connection electrode layer 39 using an adhesive layer 43. The adhesive layer 43 is a transparent adhesive layer capable of transmitting light generated in the active layer 29, and is not particularly limited as long as it is a material capable of attaching the substrate 41.

Meanwhile, the substrate 41 is a support substrate for supporting the light emitting device, and is not particularly limited as long as it is a substrate capable of transmitting light generated in the active layer 29. The substrate 41 may be, for example, a sapphire substrate.

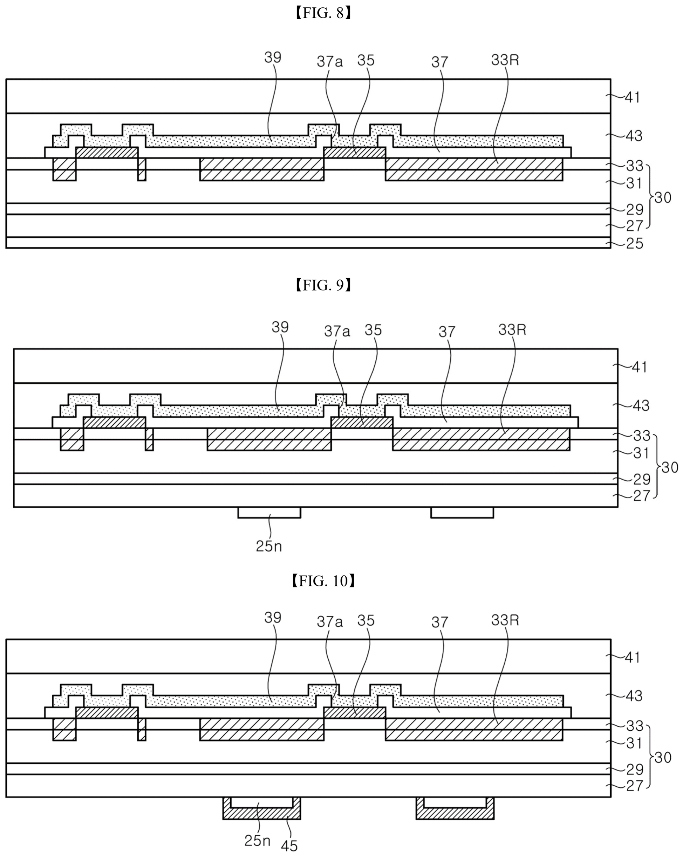

Referring to FIG. 8, after the substrate 41 is attached, the substrate 21 and the etch stop layer 23 are sequentially removed. The substrate 21 may be removed using, for example, wet etching technique. After the substrate 21 is removed, the etch stop layer 23 may be removed. In an embodiment, the etch stop layer 23 may also be removed using the wet etching technique. As the substrate 21 and the etch stop layer 23 are removed, the first conductivity type contact layer 25 is exposed.

Referring to FIG. 9, the first conductivity type contact layer 25 is patterned to form a plurality of first conductivity type contact layers 25n spaced apart from one another. As shown in FIG. 1A, the first conductivity type contact layers 25n may be distributed on the first conductivity type window layer 27. The first conductivity type contact layers 25n may be disposed between the second ohmic layers 35 not to overlap with the second ohmic layers 35 in a vertical direction.

The first conductivity type contact layers 25n may be arranged at equal intervals from one another in a matrix, but the inventive concepts are not limited thereto. For example, the first conductivity type contact layers 25n may be arranged in a honeycomb shape.

Referring to FIG. 10, first ohmic layers 45 may be respectively formed on the first conductivity type contact layers 25n. The first ohmic layers 45 are in ohmic contact with the first conductivity type contact layers 25n. The first ohmic layers 45 may be formed of, for example, metal such as AuGe, PdGe, or the like. In an embodiment, the first ohmic layer 45 may cover a bottom and side surfaces of the first conductivity type contact layer 25n.

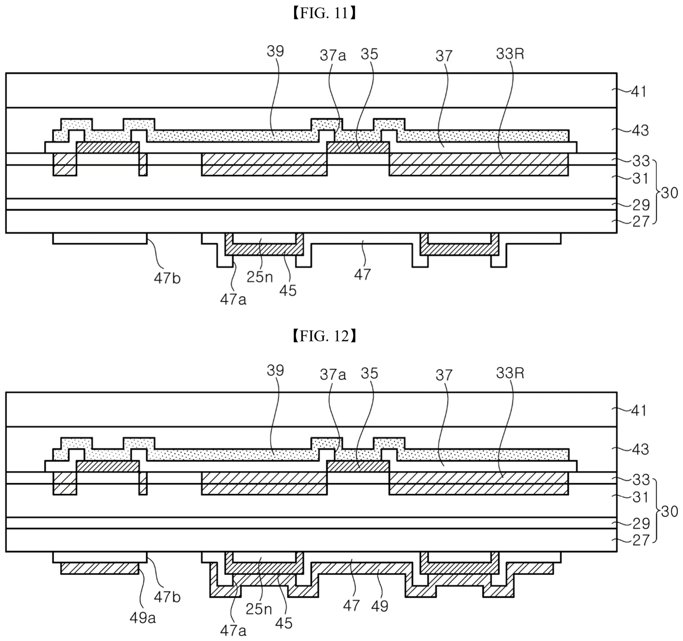

Referring to FIG. 11, a second insulation layer 47 may be formed on the first ohmic layers 45 and the first conductivity type window layer 27. The second insulation layer 47 may be formed of, for example, a silicon oxide layer. The second insulation layer 47 covers the first ohmic layers 45 and the first conductivity type window layer 27.

The second insulation layer 47 may be patterned to have first openings 47a exposing the first ohmic layers 45 and second openings 47b exposing the first conductivity type window layer 27 in a region for forming a hole. In addition, the second insulation layer 47 may be patterned to expose the first conductivity type window layer 27 around an edge thereof.

Referring to FIG. 12, a second connection electrode layer 49 is formed on the second insulation layer 47. The second connection electrode layer 49 may connect the first ohmic layers 45 exposed by the first openings 47a of the second insulation layer 47 to one another. The first connection electrode layer 49 is not particularly limited as long as it is conductive, but may be formed of a reflective metallic layer such as Au to improve light extraction efficiency.

The second connection electrode layer 49 may be patterned to have an opening 49a exposing the first conductivity type window layer 27 in a region for forming a hole. In addition, the second connection electrode layer 49 may be patterned to be limitedly disposed on the second insulation layer 47.

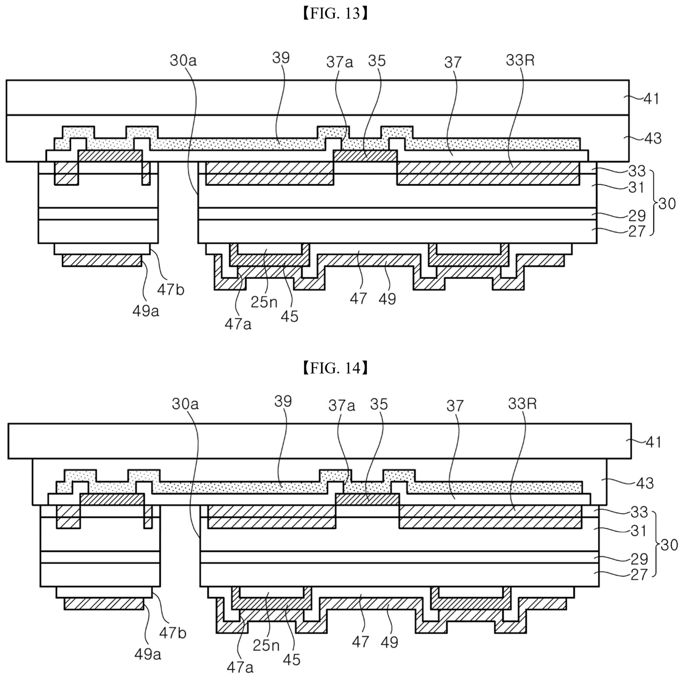

cReferring to FIG. 13, holes 30a passing through a semiconductor stack 30 may be formed. As shown in FIG. 1A, the holes 30a may be formed in a region where a second electrode pad 53b is formed. The first insulation layer 37 may be exposed through the holes 30a.

Meanwhile, while the holes 30a is formed, the semiconductor stack 30 in a device isolation region may be removed together, and the adhesive layer 43 around a side surface of the semiconductor stack 30 may be exposed.

Referring to FIG. 14, the exposed adhesive layer 43 may be patterned to expose the substrate 41. An outer boundary of the adhesive layer 43 may be disposed between an outer boundary of the semiconductor stack 30 and an outer boundary of the substrate 41. A side surface of the adhesive layer 43 may protrude outwardly more than the side surface of the semiconductor stack 30, without being limited thereto, and the side surface of the adhesive layer 43 and the side surface of the semiconductor stack 30 may be in flush with each other.

The adhesive layer 43 may be patterned using photolithography and etching techniques, and the hole 30a may be covered with an etching mask such as photoresist while the adhesive layer 43 is patterned.

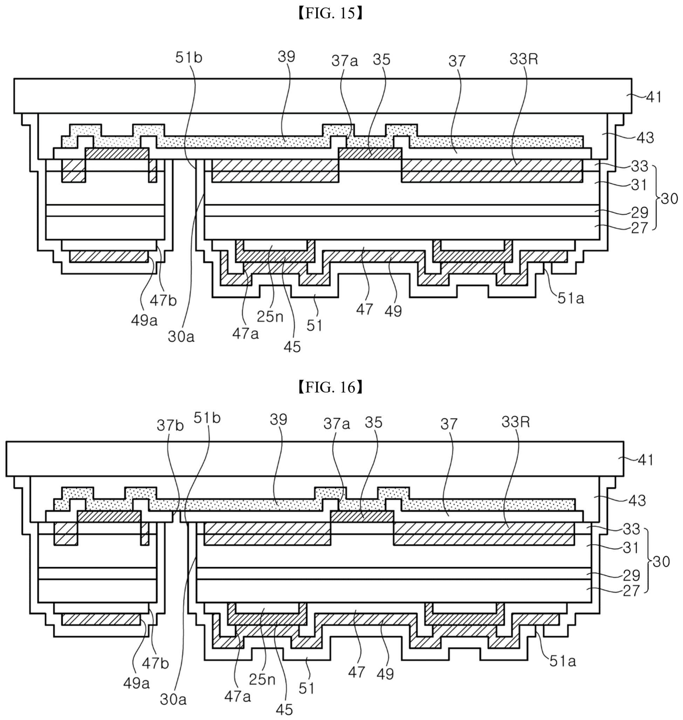

Referring to FIG. 15, a third insulation layer 51 covering the second connection electrode layer 49, the semiconductor stack 30, the adhesive layer 43, and the substrate 41 is formed. The third insulation layer 51 may be formed using insulation layers having different refractive indices from one another, and may include, for example, a distributed Bragg reflector. The third insulation layer 51 may cover a sidewall of the hole 30a, and may cover the side surface of the semiconductor stack 30 and the side surface of the adhesive layer 43.

Meanwhile, the third insulation layer 51 may be patterned to have first openings 51a exposing the second connection electrode layer 49 and second openings 51b exposing the first insulation layer 37 in the hole 30a. In addition, the third insulation layer 51 may be patterned to expose the substrate 41.

Referring to FIG. 16, a second opening 37b may be formed by patterning the first insulation layer 37 exposed at a bottom of the hole 30a. The first connection electrode layer 39 is exposed through the first opening 37b. The second opening 37b may be formed together while a second opening 51b of the third insulation layer 51 is formed.

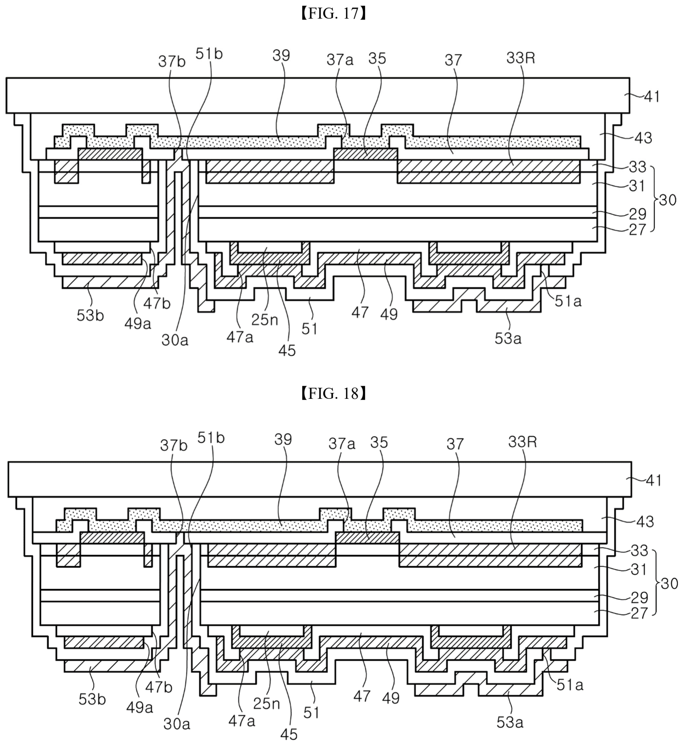

Referring to FIG. 17, first and second electrode pads 53a and 53b are formed on the third insulation layer 51. The first electrode pad 53a may be electrically connected to the second connection electrode layer 49 through the first opening 51a of the third insulation layer 51, and the second electrode pad 53b may be electrically connected to the first connection electrode layer 39 through the second opening 51b of the third insulation layer 51 and the second opening 37b of the first insulation layer 37.

Thereafter, the light emitting device shown in FIGs. 1A and 1B may be fabricated by singularizing the substrate 41 exposed in the device isolation region into individual device units.

FIG. 18 is a schematic cross-sectional view illustrating a light emitting device according to a second embodiment of the present disclosure.

Referring to FIG. 18, the light emitting device according to the second embodiment is substantially similar to the light emitting device according to the first embodiment described with reference to FIGs. 1A and 1B, except that a side surface of a first insulation layer 37 is in flush with a side surface of an adhesive layer 43. According to this embodiment, the first insulation layer 37 may be used as an etching mask for etching the adhesive layer 43.

According to this embodiment, the side surface of the first insulation layer 37 may be covered with a third insulation layer 51 together with the side surface of the adhesive layer 43. In this embodiment, a side surface of a first connection electrode layer 39 is covered with the adhesive layer 43. In an embodiment, the side surface of the first connection electrode layer 39 may also be in flush with the side surface of the first insulation layer 37, and thus, the side surface of the first connection electrode layer 39 may also be covered with the third insulation layer 51.

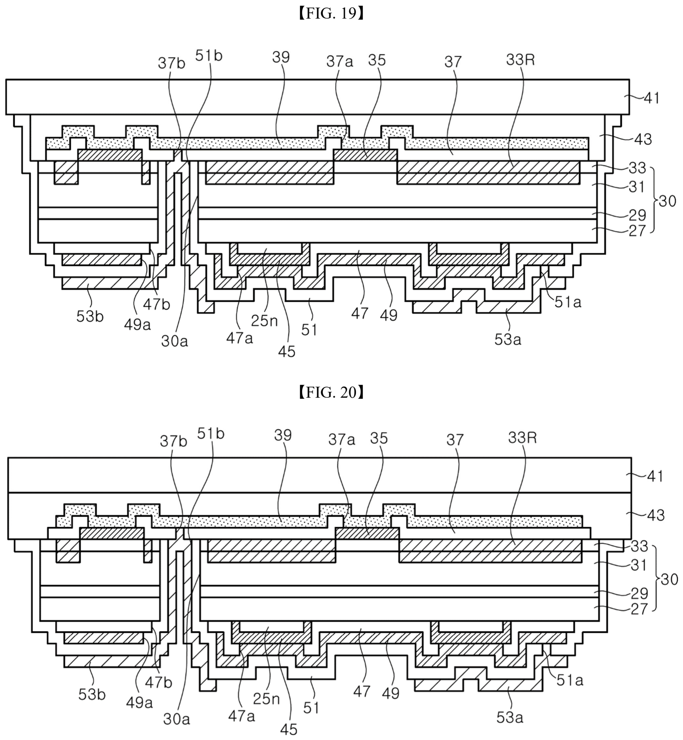

FIG. 19 is a schematic cross-sectional view illustrating a light emitting device according to a third embodiment of the present disclosure.

Referring to FIG. 19, the light emitting device according to the third embodiment is substantially similar to the light emitting device according to the first embodiment, except that a side surface of a first insulation layer 37 is in flush with a side surface of a first connection electrode layer 39. In another embodiment, the side surface of the first insulation layer 37 may be covered with the first connection electrode layer 39.

FIG. 20 is a schematic cross-sectional view illustrating a light emitting device according to a fourth embodiment of the present disclosure.

Referring to FIG. 20, the light emitting device according to the fourth embodiment is substantially similar to the light emitting device according to the first embodiment, except that a side surface of an adhesive layer 43 is in flush with a side surface of a substrate 41. For example, in a process of singularizing the light emitting device, the adhesive layer 43 and the substrate 41 may be cut together.

According to this embodiment, the side surface of the adhesive layer 43 may be exposed to the outside without being covered with a third insulation layer 51 together with the side surface of the substrate 41. Accordingly, light may be emitted even through the side surface of the adhesive layer 43.

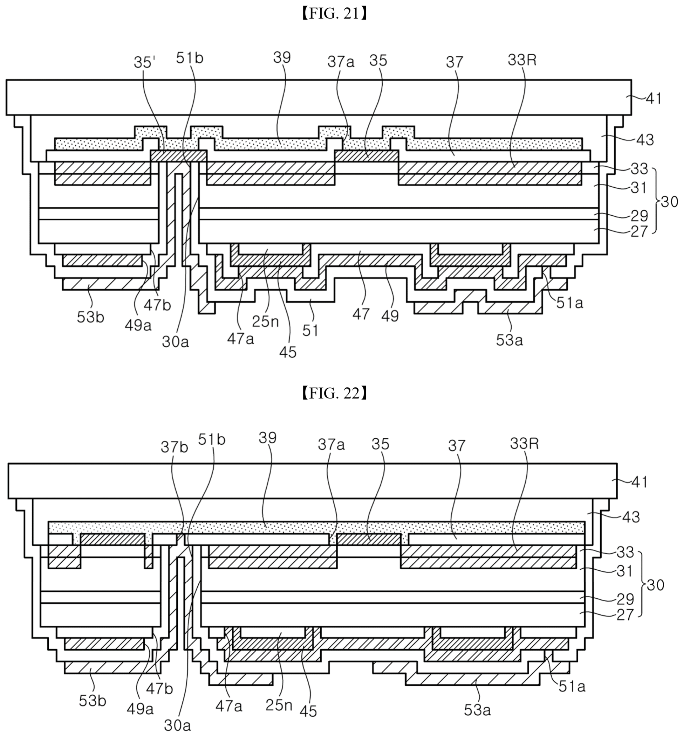

FIG. 21 is a schematic cross-sectional view illustrating a light emitting device according to a fifth embodiment of the present disclosure.

Referring to FIG. 21, the light emitting device according to the fifth embodiment is substantially similar to the light emitting device according to the first embodiment, except that that a second ohmic layer 35' is added. The second ohmic layer 35' may be disposed over a hole 30a, and may be exposed when the hole 30a is formed. Accordingly, a process of forming a second opening 37b of a first insulation layer 37 may be omitted. A first connection electrode layer 39 may electrically connect second ohmic layers 35 and the second ohmic layers 35'. A second electrode pad 53b may be electrically connected to the second ohmic layer 35' through a second opening 51b of a third insulation layer 51.

FIG. 22 is a schematic cross-sectional view illustrating a light emitting device according to a sixth embodiment of the present disclosure.

Referring to FIG. 22, the light emitting device according to the sixth embodiment is substantially similar to the light emitting device according to the first embodiment, except that sizes of first openings 37a of a first insulation layer 37 and first openings 47a of a second insulation layer 47 in this embodiment are different from those in the first embodiment. That is, in the light emitting device of the first embodiment, each of the first openings 37a of the first insulation layer 37 is limited to an upper region of the second ohmic layer 35, but in this embodiment, the first openings 37a of the first insulation layer 37 have an area larger than that of the second ohmic layer 35. Accordingly, the second ohmic layer 35 may be disposed within the first opening 37a.

In addition, in the light emitting device of the first embodiment, each of the first openings 47a of the second insulation layer 47 is limited to an upper region of the first ohmic layer 45, but in this embodiment, the first openings 47a of the second insulation layer 47 have an area larger than that of the first ohmic layer 45. Accordingly, the first ohmic layer 45 may be disposed within the first opening 47a.

According to this embodiment, the second ohmic layers 35 may be formed after the first openings 37a are formed by patterning the first insulation layer 37. Accordingly, the second ohmic layers 35 may be formed using a lift-off technique using an etching mask used to pattern the first insulation layer 37, and thus, the number of mask processes may be reduced. Furthermore, since the first insulation layer 37 and the second insulation layer 47 do not cover the ohmic layers 35 and 45, a step difference in the device may be reduced.

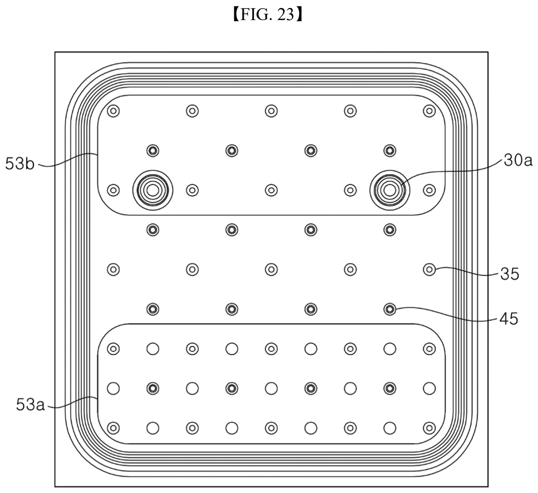

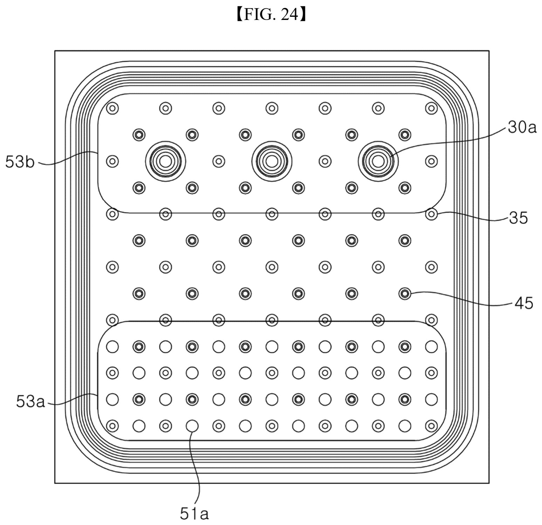

FIGs. 23 and 24 are schematic plan views illustrating light emitting devices according to various embodiments.

Referring to FIG. 23, a light emitting device according to this embodiment is substantially similar to the light emitting device according to the first embodiment, except that holes 30a are disposed closer to a center of the light emitting device, and furthermore, the number of first ohmic layers 45 and second ohmic layers 35 is further increased, and the number of first openings 51a of a third insulation layer 51 is increased. By disposing the holes 30a closer to the center of the light emitting device, current may be more evenly spread over an entire region of the light emitting device, and by disposing the first and second ohmic layers 45 and 35 more densely, the current may be further spread. In addition, by increasing the number of the first openings 51a of the third insulation layer 51, electrical connection between a first electrode pad 53a and a second connection electrode layer 49 may be enhanced.

Referring to FIG. 24, a light emitting device according to this embodiment is generally similar to the light emitting device according to the first embodiment, except that the number of holes 30a is further increased, and furthermore, the number of first ohmic layers 45 and second ohmic layers 35 is further increased, and the number of first openings 51a of a third insulation layer 51 is further increased.

Current dissipation performance may be improved by increasing the number of via holes 30a, and current may be further spread by disposing the first and second ohmic layers 45 and 35 more densely. In addition, by increasing the number of the first openings 51a of the third insulation layer 51, electrical connection between a first electrode pad 53a and a second connection electrode layer 49 may be enhanced.

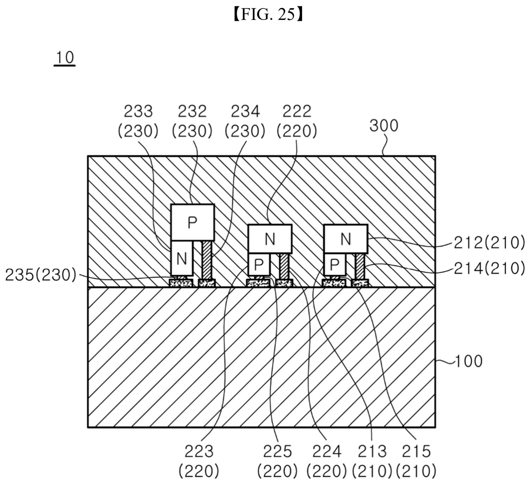

FIG. 25 describes a module 10 and a display apparatus including the same according to an embodiment of the present disclosure.

The module 10 and the display apparatus including the same may include a plurality of light emitting devices 210, 220, and 230, and a base substrate 100 may support the plurality of light emitting devices 200 and a molding layer 300. The base substrate 100 may be a printed circuit board and may be formed of an insulating material.

The plurality of light emitting devices 200 may be supported on the base substrate 100 to emit light. At least one of the plurality of light emitting devices 210, 220, and 230 may be different in an arrangement of a p-type semiconductor layer and an n-type semiconductor layer. For example, in one or more light emitting devices 230 among the plurality of light emitting devices 210, 220, and 230, a p-type semiconductor layer 232 may be disposed above an n-type semiconductor layer 233. In addition, in the other light emitting devices 210 and 220, n-type semiconductor layers 212 and 222 may be disposed above p-type semiconductor layers 213 and 223, respectively. The light emitting device 230 in which the p-type semiconductor layer and the n-type semiconductor layer are disposed differently may be a third light emitting device 230 emitting red light. The plurality of light emitting devices 210, 220, and 230 may be directly connected to the base substrate 100 using a conductive material.

The molding layer 300 may cover the plurality of light emitting devices 210, 220, and 230, and may improve light extraction efficiency of the plurality of light emitting devices 210, 220, and 230. In addition, the molding layer 300 may encapsulate the plurality of light emitting devices 210, 220, and 230, and may refract light emitted from the plurality of light emitting devices 210, 220, and 230. In addition, the molding layer 300 may be a lighttransmitting transparent molding for transmitting light emitted from the plurality of light emitting devices 210, 220, and 230, and for example, may be formed of a resin including at least one of a silicone-based, an epoxy-based, a polymethyl methacrylate (PMMA)-based, a polyethylene (PE)-based, and a polystyrene (PS)-based resins. In addition, the molding layer 300 may be formed of a fluorine resin to improve light efficiency emitted from the plurality of light emitting devices 210, 220, and 230.

Meanwhile, the molding layer 300 may include a light diffusing or light blocking material capable of diffusing or blocking light emitted from the plurality of light emitting devices 210, 220, and 230. For example, the light diffusing or light blocking material may include one or more of TiO2, BaO, SiO2, MgO, and Y2O3, and may be distributed inside the molding layer 300.

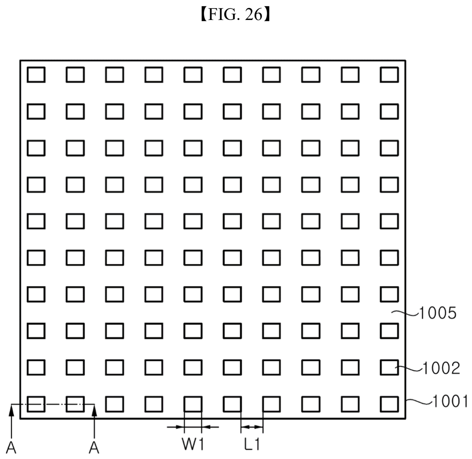

FIG. 26 is a cross-sectional view illustrating an example in which a light emitting apparatus according to another embodiment of the present disclosure is applied to a display panel. The display panel may be applied to a signage or a display apparatus, a vehicle, and the like.

The display panel includes a circuit board 1001, pixels 1002, and a buffer material layer 1005.

The circuit board 1001 or a panel substrate may include a circuit for passive matrix driving or active matrix driving. In an embodiment, the circuit board 1001 may include interconnections and resistors therein. In another embodiment, the circuit board 1001 may include interconnections, transistors, and capacitors. The circuit board 1001 may also have pads 1003 on its upper surface to allow electrical connection to the circuit disposed therein.

A plurality of pixels 1002 is arranged on the circuit board 1001. The pixel 1002 may be a small light emitting device having a size of a micro unit, and a width W1 may have a size of 1000µm or less. In an embodiment, an interval L1 between the pixels 1002 in a direction in which the pixels 1002 are arranged may be wider than the width W1 of the pixels 1002 in that direction. Alternatively, to adjust the number of pixels, the interval L1 between the pixels 1002 in the direction in which the pixels 1002 are arranged may be narrower than the width W1 of the pixels 1002 in that direction. Each of the pixels 1002 includes a plurality of light emitting devices. For example, each of the pixels 1002 may include blue, green, and red subpixels.

The buffer material layer 1005 may cover the circuit board 1001 between the pixels 1002, and may cover upper surfaces of the pixels 1002. The buffer material layer 1005 may also include a matrix that is transparent to light, but the inventive concepts are not limited thereto. For example, the buffer material layer 1005 may reflect or absorb light, and for this purpose, a matrix having light reflection characteristics or a matrix having light absorption characteristics may be used. Alternatively, a light absorbing material such as carbon black or a light scattering material such as silica may be contained in the matrix.

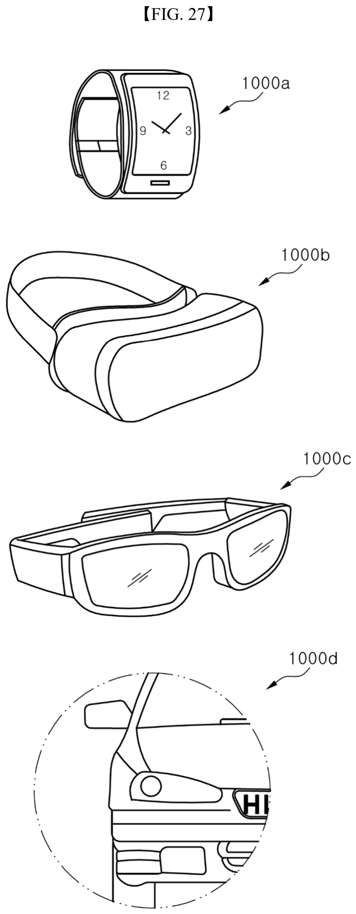

Referring to FIG. 27, a light emitting apparatus according to an embodiment of the present disclosure may be used for a VR display apparatus such as a smart watch 1000a or a VR headset 1000b, an AR display apparatus such as an augmented reality glasses 1000c, or a display apparatus such as signage. Alternatively, it may be applied to a display of a vehicle 1000d to implement a character string (English, numeric, Korean, etc.) or an icon such as a picture. A display apparatus may be networked with an external source to implement characters or icons designated by a user. The external source may be an application or a system setting installed in the vehicle.

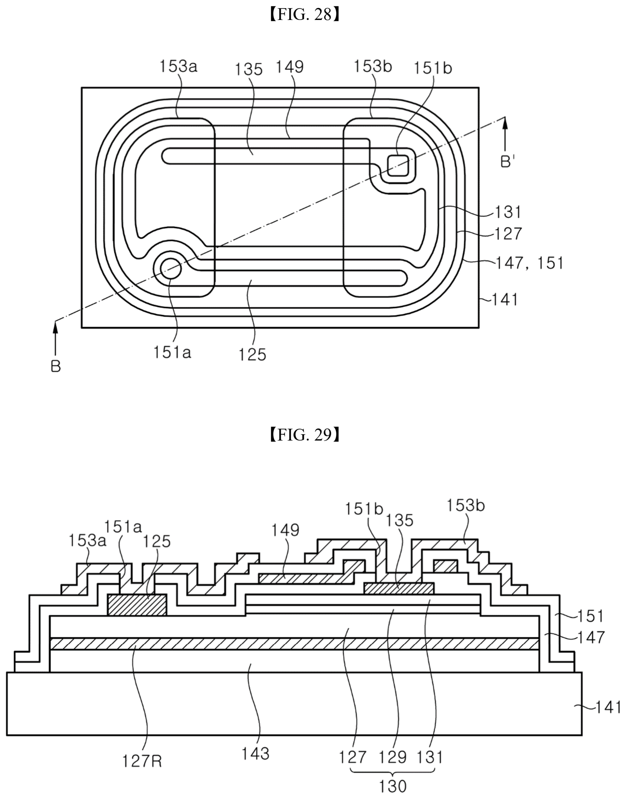

FIG. 28 is a schematic plan view illustrating a light emitting device according to a seventh embodiment, and FIG. 29 is a schematic cross-sectional view taken along line B-B' of FIG. 28.

Referring to FIGs. 28 and 29, the light emitting device according to the seventh embodiment may include a substrate 141, a semiconductor stack 130, a first ohmic layer 125, a second ohmic layer 135, and a lower insulation layer 147, an adhesive layer 143, a reflection metal layer 149, an upper insulation layer 151, a first electrode pad 153a, and a second electrode pad 153b. The semiconductor stack 130 may include a first conductivity type window layer 127, an active layer 129, and a second conductivity type window layer 131.

The substrate 141 is for supporting the light emitting device, and bonded to the semiconductor layers through the adhesive layer 143. The substrate 141 is distinct from a growth substrate used to grow the semiconductor stack 130. A type of substrate 141 is not particularly limited as long as it transmits light generated in the active layer 129, and various substrates such as sapphire substrate, GaP substrate, SiC substrate, organic substrate, and others may be used.

The substrate 141 may have a rectangular or square outer shape as shown in plan view FIG 28. A size of the substrate 141 is not particularly limited and may be variously selected.

The active layer 129 is disposed between the first conductivity type window layer 127 and the second conductivity type window layer 131. The first conductivity type window layer 127, the active layer 129, and the second conductivity type window layer 131 may have a typical AlInGaP-based semiconductor stacked structure for emitting red light. The active layer 129 may have a single quantum well structure or a multiple quantum well structure, and may include an InGaP well layer and an AlInGaP barrier layer. The first conductivity type window layer 127 may be formed of, for example, an n-type AlInGaP layer, and the second conductivity type window layer 131 may be formed of, for example, a GaP layer. However, the inventive concepts are not limited thereto, and the first conductivity type window layer 127 may be formed of, for example, a GaP layer, and the second conductivity type window layer 131 may be formed of, for example, an n-type AlInGaP layer.

The first conductivity type window layer 127 may be bonded to the substrate 141 through the adhesive layer 143. A roughened surface 127R may be formed on the first conductivity type window layer 127. The roughened surface 127R may have various concavo-convex shapes. For example, as shown in FIGs. 2A, 2B, and 2C, a convex portion may have various shapes such as a pyramidal shape, a columnar shape, a saw tooth shape, and others. The roughened surface 127R may be formed using a patterning technique or chemical etching.

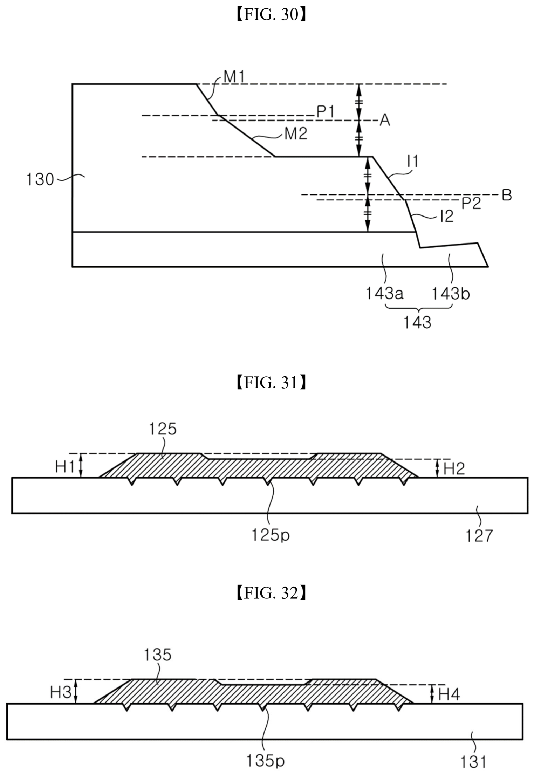

The semiconductor stack 130 may have a mesa structure. That is, the second conductivity type window layer 131 and the active layer 129 may be disposed in an upper region of the first conductivity type window layer 127. As shown in FIG. 30, a side surface of the mesa may have at least two inclined surfaces M1 and M2 having different inclination angles from each other. A first mesa inclined surface M1 may be steeper than a second mesa inclined surface M2. As shown in FIG. 30, a height of a first point P1 where the first mesa inclined surface M1 and the second mesa inclined surface M2 meet may be spaced apart from a first position A, which is 50% of a total thickness of the mesa having the first inclined surface M1 and the second inclined surface M2. The first point P1 may be disposed close to one of an upper surface or lower surface of the mesa.

A side surface of the first conductivity type window layer 127 may also include inclined surfaces I1 and I2 having different inclination angles. A stacking order of the inclined surfaces I1 and I2 with different inclination angles formed on the side surface of the first conductivity type window layer 127 may be different from the stacking order of the mesa inclined surfaces M1 and M2 with different inclination angles. For example, a first inclined surface I1 of the first conductivity type window layer 127 may be gentler than a second inclined surface I2. As shown in FIG. 30, a height of a second point P2 where the first inclined surface I1 and the second inclined surface I2 meet may be spaced apart from a second position B, which is 50% of a vertical distance from an interface between the semiconductor stack 130 and the adhesive layer 143 to an upper end of the first inclined surface I1. The second point P2 may be disposed close to one of the upper end of the first inclined surface I1 or the interface between the semiconductor stack 130 and the adhesive layer 143.

The adhesive layer 143 may be disposed between the semiconductor stack 130 and the substrate 141. The adhesive layer 143 may include for example, epoxy, polyimide, SU8, spin-on-glass (SOG), and benzocyclobutene (BCB), without being limited thereto. As shown in FIG. 29, a side surface of the adhesive layer 143 may be covered with the lower and upper insulation layers 147 and 151. An outer boundary of the adhesive layer 143 may be disposed between an outer boundary of the semiconductor stack 130 and an outer boundary of the substrate 141.

As shown in FIG. 30, the adhesive layer 143 may include an inner region 143a disposed under the semiconductor stack 130 and an outer region 143b disposed outside. The inner region 143a may be thicker than the outer region 143b. Meanwhile, the outer region 143b may include portions with different thicknesses from one another. At least some of the portions of the outer region 143b may have a thickness greater than that of a portion closer to the inner region 143a. For example, a side surface of the outer region 143b may be thicker than a boundary portion between the inner region 143a and the outer region 143b. The thicknesses of the inner region 143a and the outer region 143b are made to be different, and a side surface portion of the outer region 143b is made to be thicker than an inner portion of the outer region 143b, thereby suppressing moisture absorption through the adhesive layer 143. In cross-section view, an upper surface of the outer region 143b may include an upper inclined surface compared to a lower surface thereof.

The first ohmic layer 125 may be disposed on the first conductivity type window layer 127. The first ohmic layer 125 may be formed on the first conductivity type window layer 127 exposed by mesa etching. The first ohmic layer 125 may be in ohmic contact with the first conductivity type window layer 127. The first ohmic layer 125 may be formed of at least one metal such as Ni, Al, Ti, Sn, Au, Ge, Pd, AuGe, PdGe, and the like. For current spreading, the first ohmic layer 125 may have an elongated shape along a side surface of the substrate 141. A shape of the first ohmic layer 125 may vary, and is not limited to a specific shape.

As shown in FIG. 31, the first ohmic layer 125 may include regions with different thicknesses. For example, the first ohmic layer 125 may include a region having a first height H1 and a region having a second height H2 from the first conductivity type window layer 127. In an embodiment, a region having the second height H2 may be surrounded by a region having the first height H1. In addition, both side surface of the first ohmic layer 125 may form gently inclined surfaces. Furthermore, the first ohmic layer 125 may include protrusions 125p protruding toward an inner side of the first conductivity type window layer 127.

A roughness profile of the protrusions 125p may be different from that of the roughened surface 127R.

The second ohmic layer 135 may be disposed on the second conductivity type window layer 131. The second ohmic layer 135 may be in ohmic contact with the second conductivity type window layer 131. The second ohmic layer 135 may be formed of, for example, Ni, Al, Ti, Sn, Au, Ge, Pd, TiAu, AuBe, AuZn, and the like. For ohmic contact with the second ohmic layer 135, a second conductivity type contact layer may be disposed between the second conductivity type window layer 131 and the second ohmic layer 135. The second ohmic layer 135 may have an elongated shape parallel to the first ohmic layer 125, but the inventive concepts are not limited thereto.

As shown in FIG. 32, the second ohmic layer 135 may include regions with different thicknesses. For example, the second ohmic layer 135 may include a region having a third height H3 and a region having a fourth height H4 from the second conductivity type window layer 131. In an embodiment, the region having the fourth height H4 may be surrounded by the region having the third height H3. In addition, both side surfaces of the second ohmic layer 135 may form gently inclined surfaces. Furthermore, the second ohmic layer 135 may include protrusions 135p protruding toward an inner side of the second conductivity type window layer 131. The protrusions 135p may have a regular shape, or although not shown in the drawings, may have an irregular shape.

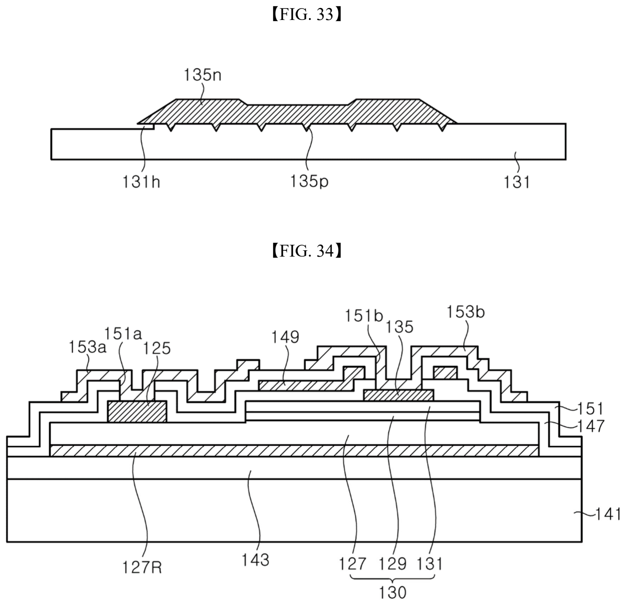

In another embodiment, the first conductivity type window layer 127 may be a p-type semiconductor layer, and the second conductivity type window layer 131 may be an n-type. In this case, as shown in FIG. 33, a second ohmic layer 135n may be disposed on the second conductivity type window layer 131. In this case, the second ohmic layer 135n may be formed of a metal such as Ni, Al, Ti, Sn, Au, Ge, Pd, AuGe, PdGe, and the like. Meanwhile, at least one end of the second ohmic layer 135n may be spaced apart from the second conductivity type window layer 131, and a gap 131h may be formed between them.

The lower insulation layer 147 covers the semiconductor stack 130, the first ohmic layer 125, and the second ohmic layer 135. The lower insulation layer 147 may cover a side surface of the semiconductor stack 130, and further, may cover a side surface of the adhesive layer 143. In addition, the lower insulation layer 147 may cover at least a portion of an upper surface of the substrate 141. As shown in FIG. 29, the portion of the upper surface of the substrate 141 may be exposed without being covered by the lower insulation layer 147. In another embodiment, an entire upper surface of the substrate 141 may be covered with the lower insulation layer 147.

The reflection metal layer 149 may be disposed on the lower insulation layer 147. In an embodiment, the reflection metal layer 149 may be disposed in an upper region of the second conductivity type window layer 131. The reflection metal layer 149 may be formed of a metal reflection layer that reflects light generated in the active layer 129, and may be formed of Au, for example. An omni-directional reflector may be formed by the lower insulation layer 147 and the reflection metal layer 149.

The reflection metal layer 149 may partially overlap the second ohmic layer 135. The reflection metal layer 149 may be formed to expose at least a portion of the second ohmic layer 135 to allow electrical connection to the second ohmic layer 135.

The reflection metal layer 149 may be limitedly disposed on the lower insulation layer 147, and thus, the lower insulation layer 147 may be exposed around an edge of the reflection metal layer 149.

The upper insulation layer 151 may be disposed on the reflection metal layer 149. The upper insulation layer 151 may cover the side surface of the semiconductor stack 130, further, may cover the side surface of the adhesive layer 143, and may be in contact with the substrate 141. The upper insulation layer 151 may cover side surfaces of the lower insulation layer 147 and the reflection metal layer 149.

The upper insulation layer 151 and the lower insulation layer 147 may have openings 151a and 151b to allow electrical connection to the first ohmic layer 125 and the second ohmic layer 135. The openings 151a and 151b are spaced apart from the reflection metal layer 149. The openings 151a and 151b may be disposed over the first and second ohmic layers 125 and 135, respectively, and thus, the first and second ohmic layers 125 and 135 may be exposed through the lower and upper insulation layers 147 and 151. The reflection metal layer 149 may be completely covered by the upper insulation layer 151.

In an embodiment, the upper insulation layer 151 may include a distributed Bragg reflector. Accordingly, the upper insulation layer 151 may improve light extraction efficiency by reflecting light generated in the active layer 129 toward the substrate 141. A thickness of the upper insulation layer 151 may be different from that of the lower insulation layer 147.

The first electrode pad 153a and the second electrode pad 153b may be disposed on the upper insulation layer 151. The first electrode pad 153a is electrically connected to the first ohmic layer 125 through a first opening 151a of the upper insulation layer 151. The first electrode pad 153a may be electrically connected to the first conductivity type window layer 127 through the first ohmic layer 125.

Meanwhile, the second electrode pad 153b may be electrically connected to the second ohmic layer 135 through a second opening 151b, and may be electrically connected to the second conductivity type window layer 131 through this.

The first and second electrode pads 153a and 153b are metal layers for flip-bonding the light emitting device, and may be formed of, for example, a bonding metal such as AuSn, and the like. As shown in FIG. 28, the first and second electrode pads 153a and 153b may be disposed to face each other.

According to an embodiment of the present disclosure, a light emitting device capable of flip-chip bonding while emitting red light using an AlInGaP-based semiconductor layer is provided.

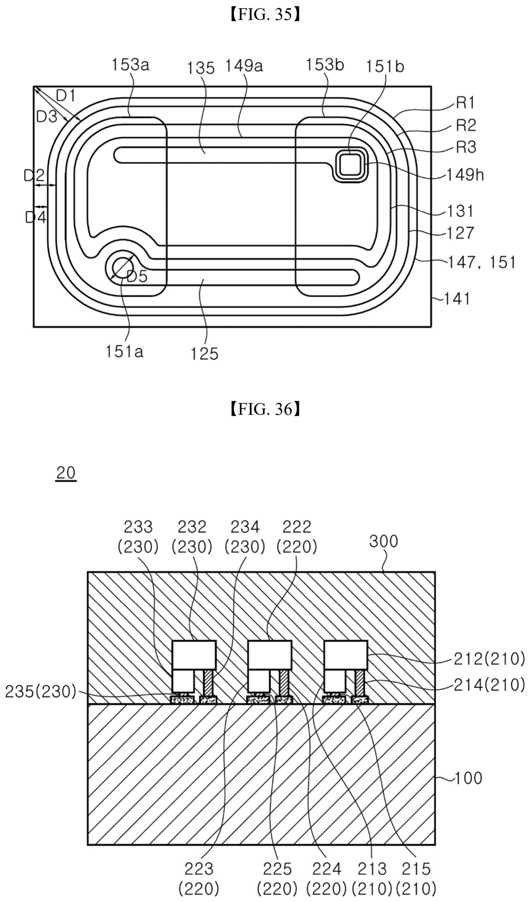

In this embodiment, edges of the first conductivity type window layer 127, the second conductivity type window layer 131, and the first and second electrode pads 153a and 153b may include curved regions, and these layers may have curved regions with different curvature from one another. This will be described in detail later with reference to FIG. 35.

According to this embodiment, by employing the semiconductor stack 130 having the mesa structure, it is possible to provide a light emitting device having a simpler structure compared to those of the previous embodiments. and capable of stable bonding.

FIG. 34 is a schematic cross-sectional view illustrating a light emitting device according to an eighth embodiment.

Referring to FIG. 34, the light emitting device according to this embodiment is generally similar to the light emitting device described with reference to FIGs. 28 and 29, except that a side surface of an adhesive layer 143 is exposed without being covered with lower and upper insulation layers 147 and 151. Side surfaces of the lower and upper insulation layers 147 and 151 may be disposed in an upper region of the adhesive layer 143. In an embodiment, the side surface of the adhesive layer 143 may be in flush with a side surface of a substrate 141, and in flush with the side surfaces of the lower and upper insulation layers 147 and 151. In another embodiment, the side surface of the adhesive layer 143 may be disposed in an upper region of the substrate 141.

FIG. 35 is a schematic plan view illustrating a light emitting device according to a ninth embodiment.

Referring to FIG. 35, the light emitting device according to this embodiment is generally similar to the light emitting device described with reference to FIGs. 28 and 29, except that a reflection metal layer 149a has an opening 149h. The opening 149h is arranged to overlap a portion of a second ohmic layer 135. In addition, the opening 149h is formed to overlap a second opening 151b. The opening 149h may be larger than the second opening 151b, and thus, the reflection metal layer 149a is not exposed through the second opening 151b.

Meanwhile, a lower or upper insulation layer 147 or151 may have a curved region having a first radius of curvature R1 near an edge of a substrate 141, and adjacent curved regions may be connected by a linear portion formed between the curved region having the first radius of curvature R1. The lower or upper insulation layer 147 or 151 may include regions near the edge of the substrate 141 where distances from the substrate 141 vary.

A first conductivity type window layer 127 may have a curved region having a second radius of curvature R2 near the edge of the substrate 141, and adjacent curved regions may be connected by a linear portion formed between the curved region having the second radius of curvature R2. The first conductivity type window layer 127 may include a region near the edge of the substrate 141 where a distance from the substrate 141 varies.

A second conductivity type window layer 131 may have a curved region having a third radius of curvature R3 near the edge of the substrate 141, and adjacent curved regions may be connected by linear portions formed between the curved regions having the third radius of curvature R3. The second conductivity type window layer 131 may include a region near the edge of the substrate 141 where a distance from the substrate 141 varies.

The first radius of curvature R1 may be different from the second radius of curvature R2. The first radius of curvature R1 may be larger than the second radius of curvature R2, and a curvature of the curved region of the lower or upper insulation layer 147 or 151 having the first radius of curvature R1 may be smaller than that of the first conductivity type window layer 127 having the second radius of curvature R2. The second radius of curvature R2 may be different from the third radius of curvature R3. The second radius of curvature R2 may be larger than the third radius of curvature R3, and a curvature of the curved region of the first conductivity type semiconductor layer 127 having the second radius of curvature R2 may be smaller than that of the second conductivity type window layer 131 having the third radius of curvature R3.

In addition, a maximum distance D1 from the edge of the substrate 141 to the first conductivity type window layer 127 may be more than twice of a shortest distance D2 from one side of the substrate 141 to a linear portion of the first conductivity type window layer 127. Therefore, even when the edge of the substrate 141 is damaged by impact, it is possible to prevent the device from being affected. A maximum distance D3 from the edge of the substrate 141 to the lower or upper insulation layer 147 or 151 may be more than twice of a shortest distance D4 from one side of the substrate 141 to a linear portion of the lower or upper insulation layer 147 or 151. Therefore, even when the edge of the substrate 141 is damaged by impact, it is possible to prevent the insulation layer from being affected. The maximum distance D1 to the first conductivity type window layer 127 may be greater than a maximum width D5 of a first ohmic layer 125.

FIG. 36 is a schematic cross-sectional view illustrating a module 20 to which embodiments are applied.

Referring to FIG. 36, the module 20 according to this embodiment is generally similar to the module 10 described with reference to FIG. 25, except that arrangements of first type semiconductor layers and second type semiconductor layers of light emitting devices 210, 220, and 230 are same. For example, all of the light emitting devices 210, 220, and 230 may have a semiconductor stack in which first type semiconductor layers 212, 222, and 232 are disposed above second type semiconductor layers 213, 223, and 233. Conversely, all of the light emitting devices 210, 220, and 230 may have a semiconductor stack in which the second type semiconductor layers 213, 223, and 233 are disposed above the first type semiconductor layers 212, 222, and 232.

The module 20 according to this embodiment may be applied to the display panel described with reference to FIG. 26 and various displays described with reference to FIG. 27.

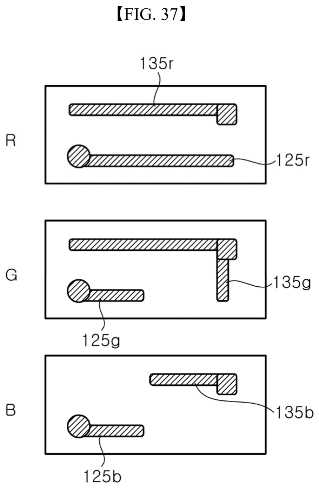

FIG. 37 is a schematic plan view illustrating various light emitting devices within a module.

Referring to FIG. 37, red, green, and blue light emitting devices (R, G, and B) may be arranged together within the module 20 as described with reference to FIG. 36. In this case, the light emitting devices (R, G, and B) may include first ohmic layers 125r, 125g, and 125b and second ohmic layers 135r, 135g, and 135b. Herein, at least one of the first ohmic layer and the second ohmic layer of the red light emitting device (R) may be distinctly different from corresponding ohmic layers of the green light emitting device (G) and the blue light emitting device (B) in shape, size, position, and others. For example, the first ohmic layer 125r may have a different length from the first ohmic layers 125g and 125b. Alternatively, the second ohmic layer 135r may have a different length or shape from the second ohmic layers 135g and 135b. The light emitting devices (R, G, and B) may be distinguished by forming the first ohmic layers 125r, 125g, and 125b or the second ohmic layers 135r, 135g, and 135b to be distinct from one another.

Although some exemplary embodiments have been described above, it should be understood that these embodiments are provided for illustration only and are not to be construed in any way as limiting the present disclosure. It should be understood that features or components of one exemplary embodiment can also be applied to other exemplary embodiments without departing from the spirit and scope of the present disclosure.

## Claims

1. A light emitting device, comprising:
a substrate;
a first conductivity type window layer and a mesa disposed on one region of the first conductivity type window layer, in which the mesa is a semiconductor stack including an active layer and a second conductivity type window layer;
an adhesive layer disposed between the semiconductor stack and the substrate;
a first ohmic layer electrically connected to the first conductivity type window layer;
a second ohmic layer electrically connected to the second conductivity type window layer; and
a first electrode pad and a second electrode pad disposed on the semiconductor stack to face the substrate, and electrically connected to the first ohmic layer and the second ohmic layer, respectively.

2. The light emitting device of claim 1,
wherein a side surface of the mesa has a plurality of inclined surfaces with different inclination angles.

3. The light emitting device of claim 2,
wherein the inclined surfaces on the side surface of the mesa become gentler as they are closer to the substrate.

4. The light emitting device of claim 2,
wherein a side surface of the first conductivity type window layer has a plurality of inclined surfaces with different inclination angles.

5. The light emitting device of claim 4,
wherein a stacking order of the inclined surfaces with different inclination angles on the side surface of the mesa is different from a stacking order of the inclined surfaces with different inclination angles on the side surface of the first conductivity type window layer.

6. The light emitting device of claim 5,
wherein the inclined surfaces on the side surface of the first conductivity type window layer become gentler as they are farther from the substrate.

7. The light emitting device of claim 1,
wherein the first ohmic layer has regions with different thicknesses from one another.

8. The light emitting device of claim 7,
wherein a region of the first ohmic layer with a relatively small thickness is surrounded by a region with a relatively large thickness.

9. The light emitting device of claim 1,
wherein the second ohmic layer has regions with different thicknesses from one another.

10. The light emitting device of claim 9,
wherein a region of the second ohmic layer with a relatively small thickness is surrounded by a region with a relatively large thickness.

11. The light emitting device of claim 1,
wherein at least one of the first ohmic layer and the second ohmic layer includes a protrusion protruding toward a corresponding window layer.

12. The light emitting device of claim 1, wherein:
the first conductivity type window layer is a p-type, the second conductivity type window layer is an n-type, and
at least one end of the second ohmic layer is spaced apart from the second conductivity type window layer.

13. The light emitting device of claim 1, wherein:
the adhesive layer includes an inner region disposed under the semiconductor stack and an outer region disposed outside the semiconductor stack, and
the inner region is thicker than the outer region.

14. The light emitting device of claim 13,
wherein the outer region includes portions of different thicknesses, and at least some of the portions of the outer region have a thickness greater than that of a portion closer to the inner region.

15. The light emitting device of claim 1, further comprising:
an insulation layer covering the first ohmic layer, the second ohmic layer, and the semiconductor stack,
wherein the first electrode pad and the second electrode pad are electrically connected to the first ohmic layer and the second ohmic layer, respectively, through openings of the insulation layer.

16. The light emitting device of claim 15, wherein:
at least a portion of an upper surface of the substrate is exposed to the outside of the adhesive layer and the insulation layer, and
a side surface of the adhesive layer is covered with the insulation layer.

17. The light emitting device of claim 15,
wherein the insulation layer covers an upper surface of the adhesive layer, and the side surface of the adhesive layer is exposed to the outside.

18. The light emitting device of claim 15, further comprising:
a reflection metal layer, wherein:
the insulation layer includes a lower insulation layer covering the first ohmic layer and the second ohmic layer and an upper insulation layer covering the lower insulation layer, and
the reflection metal layer is disposed between the lower insulation layer and the upper insulation layer.

19. The light emitting device of claim 18,
wherein the reflection metal layer is disposed over the mesa and partially overlaps the second ohmic layer.

20. The light emitting device of claim 1,
wherein the mesa, the first conductivity type window layer, and edges of the first and second electrode pads include curved regions having different curvatures from one another.
